# EUROPEAN PATENT SPECIFICATION

(11) **EP 1 011 144 B1**
(45) Date of publication and mention of the grant of the patent: **22.04.2009**
(21) Application number: 99310112.0
(22) Date of filing: 15.12.1999
(51) Int. Cl.: H01L 27/115, H01L 21/8247

(54) **Semiconductor device and manufacturing method thereof**
Halbleiterbauelement und dessen Herstellungsverfahren
Dispositif semi-conducteur et son procédé de fabrication

(30) Priority: 16.12.1998 JP 35781998
(43) Date of publication of application: 21.06.2000
(73) Proprietor: ROHM CO., LTD., Kyoto-shi, Kyoto 615-8585 (JP)
(72) Inventor: Sameshima, Katsumi, c/o Rohm Co., Ltd., Kyoto 615-8585 (JP); Kageyama, Satoshi, c/o Rohm Co., Ltd., Kyoto 615-8585 (JP)
(74) Representative: Beresford, Keith Denis Lewis

(56) References cited:
- EP-A- 0 642 167
- EP-A- 0 697 720
- DE-A- 19 640 244
- US-A- 5 612 574

## Description

This invention relates to a semiconductor device with a ferroelectric capacitor.

Semiconductors have recently been very minute in size to reduce the chip area. Accordingly contact holes are also made in minute sizes.

Along with the decrease in the size of the contact hole opening, the problem of poor conduction has surfaced as silicon which has melted into the electrode layer crystallizes around the opening. To prevent silicon from melting into the electrode layer, a barrier metal layer is provided. For the barrier metal layer, titanium (Ti) and titanium nitride (TiN) are used.

As the contact hole opening size and the aspect ratio become smaller, it becomes more difficult to deposit aluminium in the contact hole, which leads to problems such as poor conduction. To cope with this, tungsten or the like, that can be deposited even if the contact hole opening size is small, is used as the metal for filling the contact hole.

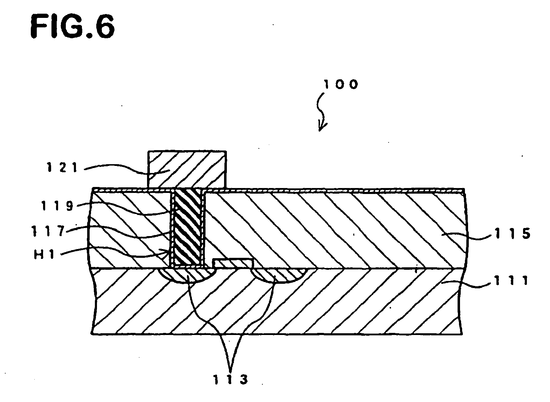

An example of semiconductor device of the conventional type being manufactured under the situation described is shown in FIG. 6 in which a semiconductor device 100 comprises a P-type substrate 111, an N-type region 113, an insulating film 115, a barrier metal layer 117, a tungsten plug 119, and an aluminium electrode layer 121.

The N-type region 113 is formed on the P-type substrate 111. The insulating film 115 is formed on the P-type substrate 111. In the insulating film 115 a contact hole is provided at a position corresponding to that of the N-type region 113. The barrier metal layer 117 is formed on a surface in the contact hole. The tungsten plug 119 is formed inside the barrier metal layer 117. The aluminium electrode layer 121 is formed so as to cover the insulation layer 115.

Such semiconductor device 100 has the following problems. Usually so far, after forming the tungsten plug 119, a metallic electrode, typically the aluminium electrode layer 121, has been formed.

However, there are increasing number of cases in which circuits other than the metallic electrode are required to be formed on the tungsten plug 119. It is an example that both a logic circuit and a ferroelectric memory circuit are placed on a single chip.

The logic circuit with the ferroelectric memory, in comparison with the conventional logic circuit with the EEPROM, is advantageous in that it can rewrite very fast and any circuit is not required to generate a high voltage for writing or write data in multiple bits at the same time. Therefore, there is a trend of replacing conventional EEPROM-mixed circuits with the ferroelectric memory-mixed logic circuits.

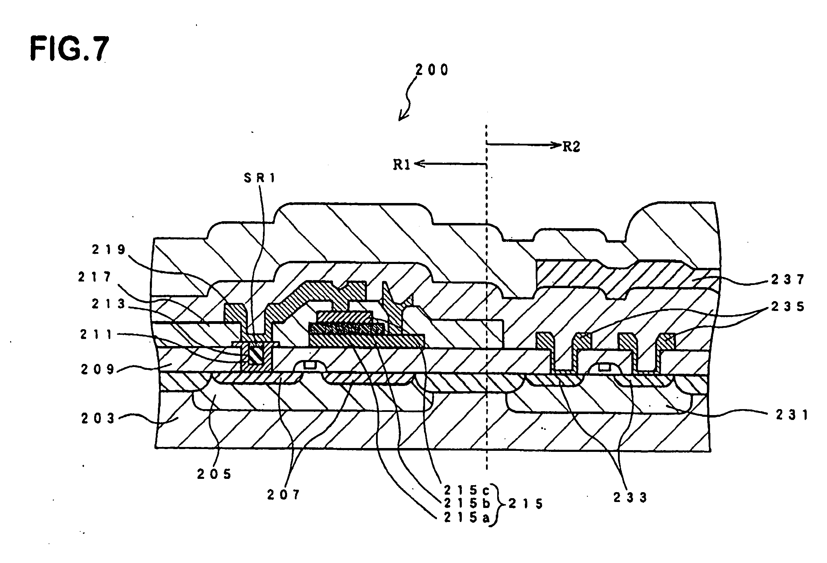

There is shown an example of the ferroelectric memory-mixed logic circuit in FIG. 7. The ferroelectric memory-mixed logic circuit 200 has a ferroelectric memory circuit section R1 and a logic circuit section R2.

In the ferroelectric memory circuit section R1 are formed on a P⁻ substrate 203, a P well 205, N⁺ region 207, a BPSG layer 209, a barrier metal layer 211, a tungsten plug 213, a ferroelectric capacitor 215, a PSG (phospho-silicate glass) layer 217, and an aluminium electrode 219. Here, the ferroelectric capacitor 215 consists of a lower electrode 215a, a ferroelectric layer 215b, and an upper electrode 215c.

In the logic circuit section R2 are formed an N well 231, a P⁺ region 233, a first aluminium electrode 235, and a second aluminium electrode 237.

After forming the ferroelectric capacitor 215 on the ferroelectric memory circuit section R1, the PSG layer 217 (oxide film) is formed on the ferroelectric capacitor 215. During the forming of the PSG layer 217, the surface of the tungsten plug 213 is undesirably oxidized, resulting in an undesirably high resistance value on the surface potion SR1.

This causes a problem that the ohmic resistance value between the tungsten plug 213 and the aluminium electrode 219 formed on the tungsten plug 213 increases and the operational speed of the semiconductor device cannot be increased.

The present invention provides methods of manufacturing a semiconductor device, as set forth in each of the attached claims, claims 1 & 2, respectively. In particular an intermediary layer is provided between a tungsten contact region and a titanium nitride metallic barrier layer. The material of this intermediary layer is chosen so that the tungsten contact region is more ohmic-conductive to the intermediary layer than to the nitride metallic barrier layer. As a consequence, an improved electrical contact is afforded.

The present invention also provides semiconductor devices as set forth in each of the attached claims, claims 6 & 7, respectively.

By way of acknowledgement, it is remarked that United States Patent US-A-5612574 discloses a semiconductor device which has, as a contact region, a conductive plug formed in an opening in an interlevel isolation layer. This plug may comprise an oxidisable material such as polycrystalline silicon which has been doped to be rendered conductive. Alternatively, it may comprise titanium nitride, titanium silicide, or other reactive metal compounds such as zirconium nitride, tantalum silicide, tungsten silicide, molybdenum silicide, nickel silicide, tantalum carbide or titanium boride. Alternatively, it may comprise other single-component semiconductors which have been doped to be rendered conductive such as single- or poly-crystalline silicon or germanium. It may comprises reactive metals such as aluminium, tungsten, tantalum, titanium or molybdenum or conductive carbides or borides, such as boron carbide. It may comprise doped compound semiconductors, such as gallium arsenide, indium phosphide, combinations of silicon and germanium and silicon carbide. The plug may also comprise a variety of combinations of the above-mentioned materials.

It is disclosed in the aforesaid United States patent that the first layer covering the contact region, namely a barrier layer, may comprise, for example, titanium nitride or ternary or greater amorphous nitrides such as Ta-Si-N, Ta-B-N, or Ti-B-N. It may also comprise a variety of exotic conductive nitrides such as Zr nitride, Hf nitride, Y nitride, Sc nitride, La nitride, and other rare earth nitrides, such as N deficient Al nitride, doped Al nitride, Ti-Al nitride, Ng nitride, Ca nitride, Sr nitride, and Ba nitride. In addition, this barrier layer may comprise alloys of the above exotic conductive nitrides with common silicon processing materials, such as titanium nitride, gallium nitride, Ni nitride, Co nitride, Ta nitride and W nitride. In addition, this layer may comprise a variety of noble metal insulator alloys such as Pt-Si-N, Pd-Si-O, Pd-B-(ON), Pd-Al-N, Ru-Si-(O,M), Ir-Si-O, ReSi-N, Rh-Al-O, Au-Si-N, or AdSi-N. It may comprise heterogeneous structures comprising multiple layers in combinations of the above referenced materials.

In the aforesaid United States patent, a second layer is interposed between the contact region and the first layer and is chosen so as to improve adhesion between the interlevel isolation layer and an electrode layer which is formed over the contact region and its covering first layer and which provides the lower electrode of a ferroelectric capacitor in the completed device. This adhesion layer may comprise an extremely thin layer of titanium, tantalum, ruthenium, or other suitable material.

European Patent application EP0 642 167 discloses a metallic contact close to a capacitor on an insulating layer. The constitution and contents of the invention will be more clearly understood from the following disclosure in consideration of the appended drawings.

### BRIEF DESCRIPTION OF THE DRAWINGS

FIG. 1 illustrates an embodiment of a semiconductor device according to the invention, showing an essential part in cross section of the semiconductor device 1.
FIG. 2A illustrates the manufacturing process of the semiconductor device 1 shown in FIG. 1.
FIG. 2B illustrates the manufacturing process of the semiconductor device 1 shown in FIG. 1.
FIG. 2C illustrates the manufacturing process of the semiconductor device 1 shown in FIG. 1.
FIG. 3A illustrates the manufacturing process of the semiconductor device 1 shown in FIG. 1.
FIG. 3B illustrates the manufacturing process of the semiconductor device 1 shown in FIG. 1.
FIG. 3C illustrates the manufacturing process of the semiconductor device 1 shown in FIG. 1.
FIG. 4A illustrates the manufacturing process of the semiconductor device 1 shown in FIG. 1.
FIG. 4B illustrates the manufacturing process of the semiconductor device 1 shown in FIG. 1.
FIG. 4C illustrates the manufacturing process of the semiconductor device 1 shown in FIG. 1.
FIG. 5A illustrates the manufacturing process of the semiconductor device 1 shown in FIG. 1.
FIG. 5B illustrates the manufacturing process of the semiconductor device 1 shown in FIG. 1.
FIG. 6 shows an essential part in cross section of a conventional semiconductor device 100.
FIG. 7 shows an example of a logic circuit formed as mixed with a ferroelectric memory.
FIG. 8 illustrates another embodiment of a semiconductor device according to the invention, showing an essential part in cross section of the semiconductor device 1.

### DESCRIPTION OF THE PREFERRED EMBODIMENT

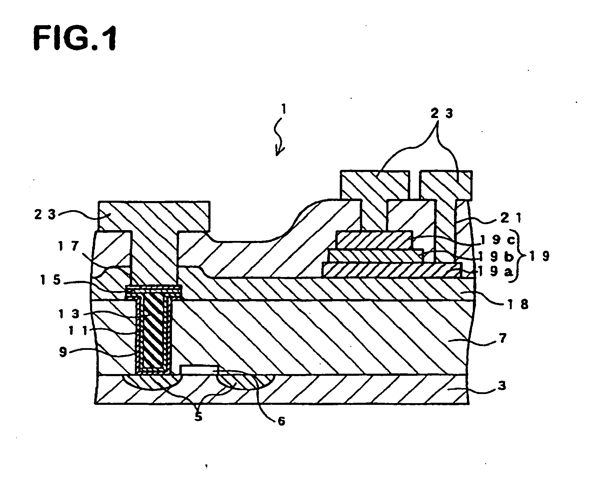

The first embodiment of the semiconductor device according to the invention is shown in FIG. 1. The semiconductor device 1 has a P-type substrate 3, an N-type region 5, a gate electrode 6, a BPSG (boro-phospho-silicate glass) layer 7, a lower titanium (Ti) layer 9, a lower titanium nitride (TiN) layer 11, a tungsten plug 13, an upper titanium (Ti) layer 15, an upper titanium nitride (TiN) layer 17, a USG (undoped silicate glass) layer 18, a ferroelectric capacitor 19, a PSG (phospho-silicate glass) layers 21, and an aluminium electrode 23.

The ferroelectric capacitor 19 has a lower electrode 19a, a ferroelectric layer 19b, and an upper electrode 19c. In this embodiment, the lower electrode 19a and the upper electrode 19c are made of iridium or iridium oxide. The ferroelectric layer 19b is made of PLZT (lead (Pb), lanthanum (La), zirconium (Zi), and titanium (Ti)).

The tungsten plug 13, serving as a contact region, is formed on a substrate, the P-type substrate 3, in a reducing atmosphere. The ferroelectric layer 19b is formed on the P-type substrate 3. The USG layer 18, serving as an oxide layer, is formed on the tungsten plug 13.

The upper titanium (Ti) layer 15 and the upper titanium nitride (TiN) layer 17 serving as oxidation preventive layers are formed to cover the tungsten plug 13.

The upper titanium (Ti) layer 16 and the upper titanium nitride (TiN) layer 17 are used as metallic barriers. Incidentally, the upper titanium (Ti) layer 15 corresponds to the second layer, and the upper titanium nitride (TiN) layer 17 corresponds to the first layer.

With the above-described configuration, as described hereinafter, the ferroelectric is prevented from deteriorating and, even if a metallic electrode is formed on the contact region, the ohmic resistance between the two parts is prevented from increasing.

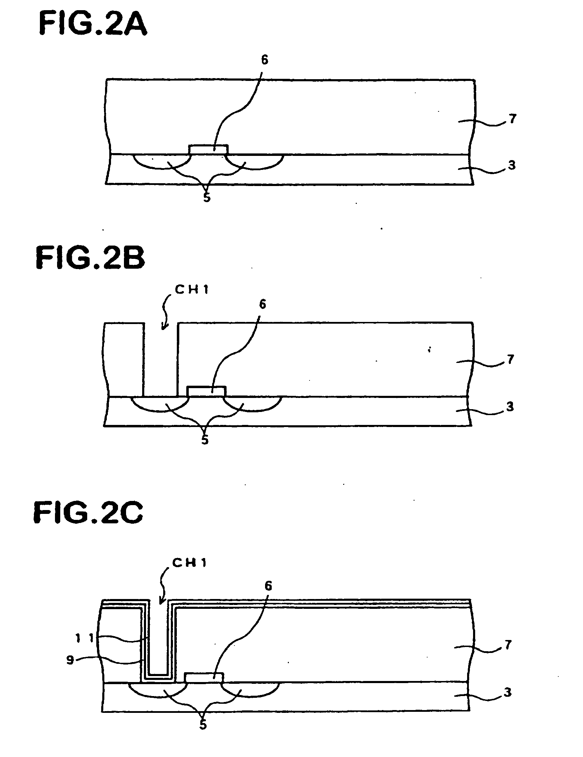

Next, the manufacturing process of the semiconductor device 1 will be described with reference to FIGs. 2 to 5. First, the N-type region 5 and the gate electrode 6 are formed on the P-type substrate 3. BPSG is deposited about 1 micrometer thick on the P-type substrate 3. After that, a re-flow process is carried out. In such a manner, the BPSG layer 7 will be formed (See FIG. 2A). The purpose of forming the BPSG layer 7 is to eliminate step features produced as a result of forming the gate electrode 6.

It may be alternatively arranged that the BPSG layer 7 is formed by SOG (spin-on-glass) etchback after depositing BPSG. Still alternatively, it may be arranged that the BPSG layer 7 is formed by CMP (chemical mechanical polishing process) after depositing BPSG.

Then a contact hole CH1 is formed at the position corresponding to the N-type region 5 (See FIG. 2B). Then, the lower titanium (Ti) layer 9 is formed by sputtering process. Next, the lower titanium nitride (TiN) layer 11 is formed by sputtering process (See FIG. 2C).

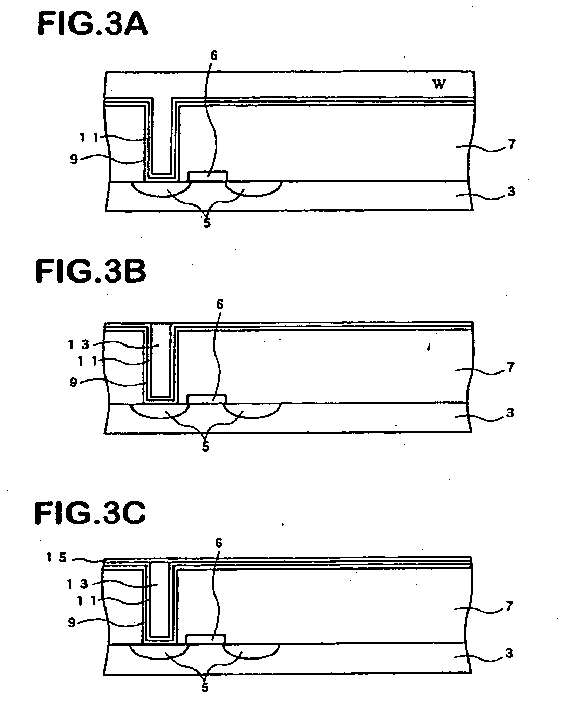

Next, tungsten is deposited in a reducing atmosphere by CVD (chemical vapor deposition) process to completely fill up the contact hole CH1 (See FIG. 3A). The deposited tungsten is etched back to a specified level. As a result, the tungsten plug 13 is formed in the contact hole CH1 (See FIG. 3B).

As described above, the tungsten plug is formed in the reducing atmosphere. It should be noted here that the ferroelectric is deteriorated in Characteristics when it is exposed to the reducing atmosphere. That is to say, when a part using the ferroelectric material and another part using tungsten are formed on the same substrate, the part using tungsten must be formed before forming the part using the ferroelectric.

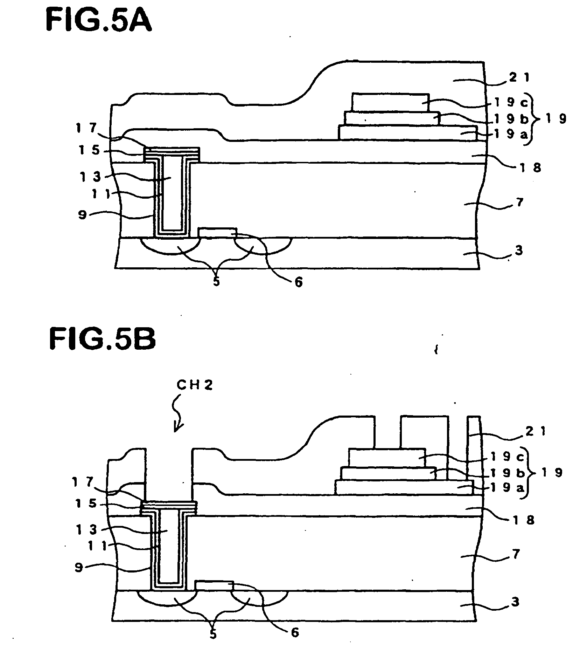

After forming the ferroelectric capacitor as will be described later in detail, the PSG layer 21 about 500 nm (5000 angstrom) thick is formed thereon (See Fig. 1 or 5B). If it were to form the contact hole after forming the PSG layer 21, it would be necessary to form the contact hole in a depth of 1.8 micrometers, same as the total thickness of: about 500 nm (5000 angstrom) thick PSG layer 21, about 1 micrometer thick BPSG layer 7, and about 300 nm (3000) angstrom thick USG layer 18.

The diameter of the contact hole formed at this time would be about 0.6 micrometers. This wound result in an aspect ratio of the contact bole of 3:1. It would be very difficult to fill the contact hole of that aspect ratio with only the metal for the contact.

On the other hand, as shown in this embodiment, if the tungsten plug 13 is formed when the BPSG layer 7 is formed, the depth of the contact hole that must be filled with the metal for the contact is the total thickness of the PSG layer 21 and the USG layer 18, or 800 nm (8000 angstroms). The aspect ratio of this contact hole is 4 : 3. Any contact hole with this aspect ratio can be sufficiently filled with the metal for the contact. In this embodiment, aluminium is used as the metal for the contact.

Here, there may be an idea of forming the plug with aluminium rather than tungsten. As described later, however, a heat treatment is carried out at high temperatures (about 600 to 800°C) when the ferroelectric capacitor is formed. Aluminium plug cannot stand such high temperatures and ends up in melting. Therefore, for a material of the plug formed after forming the BPSG layer 7, a refractory metal(a metal of a high melting point) such as tungsten is suitable as shown in this embodiment.

Subsequently, the upper titanium layer 15 is deposited over the entire surface using sputtering process (See FIG. 3C). The reason for providing the upper titanium layer 15 in such a manger is as follows: Tungsten is more ohmic-conductive to titanium than titanium nitride. Therefore, forming the upper titanium layer 15 between the tungsten plug 13 and the upper titanium nitride layer 17 improves at least the ohmic conductivity between the upper titanium nitride layer 17 and the tungsten plug 13. As a result, it is possible to make the current flow smoother between the tungsten plug 13 and the upper titanium nitride layer 17.

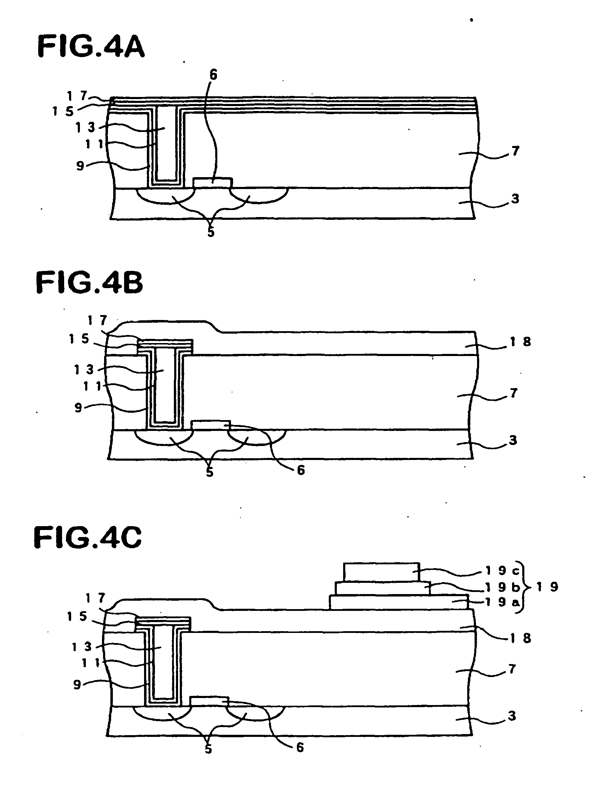

Next, the upper titanium nitride layer 17 is deposited on the upper titanium layer 15 using sputtering process (See FIG. 4A). Forming the upper titanium nitride layer 17 prevents the tungsten plug 13 from being oxidized.

Then, etching is carried out to leave the lower titanium layer 9, the lower titanium nitride layer 11, the upper titanium layer 15, and the upper titanium nitride layer 17 in specified parts around the tungsten plug 13 (See FIG. 4B).

Next, the USG layer 18 is formed by depositing USG in the thiekness of about 300 nm (3000 angstroms). The USG layer 18 is formed to insulate the tungsten plug 13 from the lower electrode 19a of a ferroelectric capacitor 19 to be formed thereafter.

Next, the ferroelectric capacitor 19 is formed on the USG layer 18. The ferroelectric capacitor 19 is formed as described below. First, iridium oxide (IrO₂) is deposited by sputtering process. Then, platinum (Pt) is deposited by sputtering process. In this way, the lower electrode 19a is formed.

Next, the ferroelectric layer 19b is formed. In this embodiment, PLZT is used as the ferroelectric. PLZT is formed by sol-gel method. First, PLZT is applied on the lower electrode 19a and then baked. The baked PLZT is crystallized with RTA(Rapid Thermal Annealing) to form the ferroelectric layer 19b.

Then, iridium (Ir) is deposited by sputtering process. Next, iridium oxide (IrO₂) is deposited by sputtering process to form the upper electrode 19c.

Next, PSG is deposited over the entire surface in a thickness of about 5000 angstroms to form the PSG layer 21 (See FIG. 5A). Then a contact hole CH2 is formed at a position corresponding to the tungsten plug 13 and the capacitor 19. Finally, the aluminium electrode is formed (not shown).

### Other Embodiments

While titanium and titanium nitride are enumerated as the barrier metals in the embodiment described any metal may be used in a not claimed method or device as long as it has the barrier function. For example, titanium, tungsten, or the like may be used.

While the plug is formed with tungsten in the embodiment described, any metal may be used in a not claimed method or device as long as it has a high melting point.

The plug may also be formed with copper in a not claimed method or device. Incidentally, a method of forming the copper plug is disclosed in *ISS Industrial & Scientific Systems, ISS14 - ISS25, '98 ULSI Symposium on Advanced Multilevel Metalization*.

Furthermore, while the upper titanium layer 15 is enumerated as an example of the second layer, the layer may be made of any material as long as the material at least improves the ohmic property between the upper titanium nitride layer 17 and the tungsten plug 13. While the upper titanium nitride layer 17 is proposed as an example of the first layer, the layer may be made of any material as long as the material has the function of preventing oxidation.

Furthermore, while the lower titanium layer 9, the lower titanium nitride layer 11, the upper titanium layer 15, and the upper titanium nitride layer 17 are etched at a time (See FIGs. 4A and 4B), they may be individually formed and etched one after another. Still alternatively, it may be arranged that the lower titanium layer 9 and the lower titanium nitride layer 11 are formed and then etched, followed by forming the upper titanium layer 15 and the upper titanium nitride layer 17 and etching them thereafter.

Still alternatively, while the first embodiment described above is of a two layer structure consisting of the upper titanium nitride layer 17 and the upper titanium layer 15, either one layer only may be formed in a not claimed method or device. For example, only the upper titanium nitride layer 17 may be formed without forming the upper titanium layer 15 in a not claimed method or device.

On the contrary, in a not claimed method or device only the upper titanium layer 15 may be formed without forming the upper titanium-nitride layer 17. With this configuration, the ohmic resistance between the tungsten plug 13 and the aluminium electrode 23 becomes lower in comparison with the configuration in which the upper titanium nitride layer 17 only is formed.

It is the reason of the reduction in the ohmic resistance that titanium in the upper titanium layer 16 takes oxygen present in the tungsten plug 13 and forms titanium oxide. Titanium oxide has a lower resistance value than tungsten oxide. Therefore, it is presumed that an overall ohmic resistance of the tungsten plug 13, the upper titanium layer 15 and the aluminium electrode 23 becomes lower.

Still alternatively, while PLZT is described in the above embodiment as an example material for forming the ferroelectric layer, other ferroelectric substances such as SBT (SrBi₂O₃, generally referred to as Y1) may be used.

Still alternatively, while the PSG layer 21 is described as an example oxide layer in the above embodiment, a USG layer using TEOS(Tetra ethyl Ortho Silicate) for example may be used as the oxide layer.

Furthermore, the USG layer 18 formed between the tungsten plug 13 and the lower electrode 19a of the ferroelectric capacitor 19 is not limited to the example shown but may be any layer as long as it can create insulation between the tungsten plug 13 and the lower electrode 19a. For example, a PSG layer or the like may be formed.

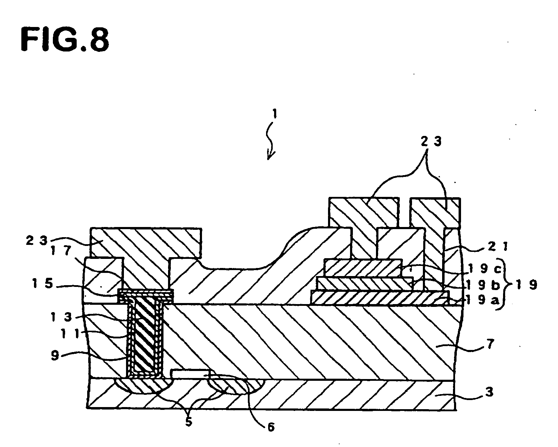

While the USG layer 18 is formed between the tungsten plug 13 and the ferroelectric capacitor 19 in the first embodiment, the USG layer 18 may be eliminated in the case the tungsten plug 13 and the lower electrode 19a of the ferroelectric capacitor 19 are formed with a sufficient mutual distance, so that they are sufficiently insulated from each other (See FIG. 8). In that case, the PSG layer 21, the oxide layer, is formed on the tungsten plug 13 and the ferroelectric layer 19b.

In this invention, the oxidation preventive layer is formed to cover the contact region. This prevents the contact region surface from being oxidized even if the oxide layer is formed after forming the contact region.

Therefore, even if the metallic electrode is placed on the contact region, ohmic resistance between them is prevented from increasing.

In the invention, the oxidation preventive layer is made of a barrier metal. Therefore, the barrier metal having a fine-grained, tight-bound structure securely prevents the contact region from being oxidized. Therefore, even if the metallic electrode is placed on the contact region, ohmic resistance between.

In the invention, the oxidation preventive layer consists of the first layer having the function of presenting oxidation of the contact region and the second layer having the function of at least improving the ohmic property between the first layer and the contact region.

As a result, the ohmic resistance is prevented from increasing by preventing the contact region from being oxidized, and the ohmic property between the contact region and the first layer is improved.

As described above, the contact region is formed in a reducing atmosphere on the substrate, an oxidation preventive layer is formed on the contact region, a ferroelectric layer is formed on the substrate and an oxide layer is formed on the ferroelectric layer or on the contact region. Therefore, there is no possibility of the ferroelectric layer deteriorating due to reducing action when the contact region is formed, and no possibility of the contact region being oxidized due to oxidizing action when the oxide layer is formed.

Therefore, there is no possibility of deterioration of the ferroelectric, and even if the metallic electrode is placed on the contact region, the ohmic resistance between them is prevented from increasing.

While the above description is made by way of preferred embodiments of the invention, each term is used not for limitation but for explanation, and may be changed without departing from the scope of the invention defined by the appended claims

## Claims

1. A method of manufacturing a semiconductor device comprising the steps of:
forming a refractory metal contact region (13) of tungsten on a substrate (3), which forming step is performed in a reducing atmosphere;
forming an intermediary layer (15) on said refractory metal contact region (13);
forming a metallic barrier layer (17) of titanium nitride on said intermediary layer (15), which metallic barrier layer (17) is to inhibit oxidation of said contact region (13) and said intermediary layer (15), and wherein the material of which said intermediary layer (15) is formed has the property that the refractory metal of said refractory metal contact region (13) is more ohmic-conductive to the material of said intermediary layer (15) than to the material of said metallic barrier layer (17);
forming a ferroelectric capacitor (19) including a lower electrode (19a), a ferroelectric layer (19b) and an upper electrode (19c) on said substrate (3), at a distance from said refractory metal contact region (13);
forming a first oxide insulation layer (21) on said metallic barrier layer (17) and on said ferroelectric capacitor (19);
forming contact holes (CII2) in said first oxide insulation layer (21) to reach said metallic barrier layer (17) and said ferroelectric capacitor lower and upper electrodes (19a, 19c); and
forming contact electrodes (23) in said contact holes (CH2).

2. The method of claim 1 further comprising the steps ot:
forming a second oxide insulation layer (18) on said metallic barrier layer (17);
forming said ferroelectric capacitor (19) on said second oxide insulation layer (18);
forming said first oxide insulation layer (21) on said second oxide insulation layer (18) over said refractory metal contact region (13);
forming said contact holes (CH2) in said first and second oxide insulation layers (18, 21).

3. The method of either preceding claim wherein said steps of forming said refractory metal contact region (13), forming said intermediary layer (15), forming said metallic barrier layer (17), and forming said contact electrode (23) are performed by depositing tungsten by chemical vapour deposition, by sputtering titanium, by sputtering titanium nitride, and by forming an aluminium contact electrode (23), respectively.

4. The method of any preceding claim wherein said step of forming said first oxide insulation layer (21) is a step of forming a layer of either phosphor-silicate glass "PSG" or undoped silicate class "USC".

5. The method of claim 2, or either of claims 3 or 4, when depending from claim 2, wherein said step of forming said second oxide insulation layer (18) is a step of forming a layer of either phosphor-silicate glass "PSG" or undoped silicate glass "USG".

6. A semiconductor device comprising:
a refractory metal contact region (13) of tungsten on a substrate (3);
an intermediary layer (15) on said refractory metal contact region (13);
a metallic barrier layer (17) of titanium nitride on said intermediary layer (15), wherein the material of said intermediary layer (15) has the property that the refractory metal of said refractory metal contact region (13) is more ohmic-conductive to the material of said intermediary layer (15) than to the material of said metallic barrier layer (17);
a second oxide insulation layer (18) on said metallic barrier layer (17);
a ferroelectric capacitor (19) including a lower electrode (19a), a ferroelectric layer (19b), and an upper electrode (19c), which ferroelectric capacitor (19) is disposed on said second oxide insulation layer (18);
a first oxide insulation layer.(21) on said ferroelectric capacitor (19) and on said second oxide insulation layer (18) over said refractory metal contact region (13);
contact holes (CH2), in said first and second oxide insulation layers (18, 21), reaching said metallic barrier layer (17) and said ferroelectric capacitor lower and upper electrodes (19a, 19c); and
contact electrodes (23) in said contact holes (CH2).

7. A semiconductor device comprising:
a refractory metal contact region (13) of tungsten on a substrate (3);
an intermediary layer (15) on said refractory metal contact region (13);
a metallic barrier layer (17) of titanium nitride on said intermediary layer (15), wherein the material of said intermediary layer (15) has the properLy that the refractory metal of said refractory metal contact region (13) is more ohmic-conductive to the material of said intermediary layer (15) than to the material of said metallic barrier layer (17);
a ferroelectric capacitor (19) including a lower electrode (19a), a ferroelectric layer (19b), and an upper electrode (19c), which ferroelectric capacitor (19) is disposed on said substrate (3) at a distance from said refractory metal contact region (13);
a first oxide insulation layer (21) on said metallic barrier layer (17) and on said ferroelectric capacitor (19);
contact holes (CH2), in said first oxide insulation layer (21), reaching said metallic barrier layer (17) and said ferroelectric capacitor lower and upper electrodes (19a, 19c); and
contact electrodes (23) in said contact holes (CH2).

8. The semiconductor device of either preceding claim 6 or 7 wherein said intermediary layer (15) and said contact electrode (23), are of titanium, and aluminium, respectively.

9. The semiconductor device of any preceding claim 6-8 wherein said first oxide insulation layer (21) is a layer of either phosphor-silicate glass "PSG" or undoped silicate glass "USG".

10. The semiconductor device of claim 6, or either preceding claim 8 or 9 when depending from claim 6, wherein said second oxide insulation layer (18) is a layer of either phosphor-silicate glass "PSG" or undoped silicate glass "USG".

## Patentansprüche

1. Eine Methode zur Herstellung eines Halbleiterbauteils, die die folgenden Schritte umfaßt:
Bildung eines hitzebeständigen metallischen Kontaktbereichs (13) aus Wolfram auf einem Substrat (3), wobei dieser Bildungsschritt in reduzierender Atmosphäre durchgeführt wird;
Bildung einer Zwischenschicht (15) auf besagtem hitzebeständigem metallischem Kontaktbereich (13);
Bildung einer metallischen Grenzschicht (17) aus Titannitrid auf der besagten Zwischenschicht (15), wobei die metallische Grenzschicht (17) eine Oxidierung des besagten Kontaktbereichs (13) und der besagten Zwischenschicht (15) unterbinden soll, und wobei das Material, aus dem die besagte Zwischenschicht (15) gebildet wird, die Eigenschaft besitzt, daß das hitzebeständige Metall des besagten hitzebeständigen metallischen Kontaktbereichs (13) mit dem Material der besagten Zwischenschicht (15) höherohmig leitend verbunden ist als mit dem Material der besagten metallischen Grenzschicht (17);
Bildung eines ferroelektrischen Kondensators (19), der eine untere Elektrode (19a), eine ferroelektrische Schicht (19b) und eine obere Elektrode (19c) auf dem besagten Substrat (3) enthält und in einem gewissen Abstand von dem besagten hitzebeständigen metallischen Kontaktbereich (13) liegt;
Bildung einer ersten Oxid-Isolationsschicht (21) auf der besagten metallischen Grenzschicht (17) und auf dem ferroelektrischen Kondensator (19);
Bildung von Kontaktlöchern (CH2) in der besagten ersten Oxid-Isolationsschicht (21), um die besagte metallische Grenzschicht (17) und die besagte untere und obere Elektrode (19a, 19c) des ferroelektrischen Kondensators (19) erreichen zu können, und
Bildung von Kontaktelektroden (23) in besagten Kontaktlöchern (CH2).

2. Die Methode gemäß Anspruch 1, die zudem die Schritte umfasst:
Bildung einer zweiten Oxid-Isolationsschicht (18) auf der besagten metallischen Grenzschicht (17);
Bildung des besagten ferroelektrischen Kondensators auf der besagten zweiten Oxid-Isolationsschicht (18);
Bildung der besagten ersten Oxid-Isolationsschicht (21) auf der besagten zweiten Oxid-Isolationsschicht (18) über dem besagten hitzebeständigen metallischen Kontaktbereich (13);
Bildung von Kontaktlöchern (CH2) in der besagten ersten und der besagten zweiten Oxid-Isolationsschicht (18,21).

3. Die Methode gemäß einem der vorhergehenden Ansprüche, wobei die besagten Schritte der Bildung des besagten hitzebeständigen metallischen Kontaktbereichs (13), der Bildung der besagten Zwischenschicht (15), der Bildung der besagten metallischen Grenzschicht (17) und die Bildung der besagten Kontaktelektrode (23) wie folgt ausgeführt werden, daß Wolfram durch Abscheidung der Gasphase aufgetragen wird, durch Zerstäubung von Titan, durch Zerstäubung von Titannitrid beziehungsweise durch Bildung einer Kontaktelektrode aus Aluminium (23).

4. Die Methode gemäß einem der vorhergehenden Ansprüche, wobei der besagte Schritt der Bildung der besagten ersten und zweiten Oxid-Isolationsschicht (18, 21) ein Schritt ist, bei dem eine Schicht aus Phosphor-Silikatglas "PSG" oder aus undotiertem Silikatglas "USG" gebildet wird.

5. Die Methode gemäß Anspruch 2, oder einem der Ansprüche 3 oder 4, wenn sie von Anspruch 2 abhängen, wobei der besagte Schritt der Bildung der besagten ersten Oxid-Isolationsschicht (21) ein Schritt ist, bei dem eine Schicht entweder aus Phosphor-Silikatglas "PSG" oder aus undotiertem Silikatglas "USG" gebildet wird.

6. Ein Halbleiterbauteil umfassend:
einen hitzebeständigen metallischen Kontaktbereich (13) aus Wolfram auf einem Substrat (3);
eine Zwischenschicht (15) auf dem besagten hitzebeständigen metallischen Kontaktbereich (13);
eine metallische Grenzschicht (17) aus Titannitrid auf der besagten Zwischenschicht (15), wobei das Material der besagten Zwischenschicht (15) die Eigenschaft besitzt, daß das hitzebeständige Metall des besagten hitzebeständigen metallischen Kontaktbereichs (13) mit dem Material der besagten Zwischenschicht (15) höherohmig leitend verbunden ist als mit dem Material der besagten metallischen Grenzschicht (17);
eine zweite Oxid-Isolationsschicht (18) auf der besagten metallischen Grenzschicht (17);
ein ferroelektrischer Kondensator (19), der eine untere Elektrode (19a), eine ferroelektrische Schicht (19b) und eine obere Elektrode (19c) auf dem besagten Substrat (3) enthält, wobei der ferroelektrische Kondensator (19) auf der zweiten Oxid-Isolationsschicht (18) angebracht ist;
eine erste Oxid-Isolationsschicht (21) auf dem besagten ferroelektrischen Kondensator (19) und auf der zweiten Oxid-Isolationsschicht (18) über dem besagten hitzebeständigen metallischen Kontaktbereich (13);
Kontaktlöcher (CH2) in der besagten ersten und zweiten Oxid-Isolationsschicht (18, 21), die die besagte metallische Grenzschicht (17) und die besagte untere und obere Elektrode (19a, 19c) des ferroelektrischen Kondensators (19) erreichen, und
Kontaktelektroden (23) in besagten Kontaktlöchern (CH2).

7. Ein Halbleiterbauteil umfassend:
einen hitzebeständigen metallischen Kontaktbereich (13) aus Wolfram auf einem Substrat (3);
eine Zwischenschicht (15) auf dem besagten hitzebeständigen metallischen Kontaktbereich (13);
eine metallische Grenzschicht (17) aus Titannitrid auf der besagten Zwischenschicht (15), wobei das Material der besagten Zwischenschicht (15) die Eigenschaft besitzt, daß das hitzebeständige Metall des besagten hitzebeständigen metallischen Kontaktbereichs (13) mit dem Material der besagten Zwischenschicht (15) höherohmig leitend verbunden ist als mit dem Material der besagten metallischen Grenzschicht (17);
ein ferroelektrischer Kondensator (19), der eine untere Elektrode (19a), eine ferroelektrische Schicht (19b) und eine obere Elektrode (19c) auf dem besagten Substrat (3) enthält und der in einem gewissen Abstand von dem besagten hitzebeständigen metallischen Kontaktbereich (13) angebracht ist;
eine erste Oxid-Isolationsschicht (21) auf der besagten metallischen Grenzschicht (17) und auf dem besagten ferroelektrischen Kondensator (19);
Kontaktlöcher (CH2) in der besagten ersten Oxid-Isolationsschicht (21), die die besagte metallische Grenzschicht (17) und die besagte untere und obere Elektrode (19a, 19c) des ferroelektrischen Kondensators (19) erreichen, und Kontaktelektroden (23) in besagten Kontaktlöchern (CH2).

8. Das Halbleiterbauteil eines der vorgehenden Ansprüche 6 oder 7, wobei die besagte Zwischenschicht (15) und die besagte Kontaktelektrode (23) aus Titan beziehungsweise aus Aluminium sind.

9. Das Halbleiterbauteil eines der vorgehenden Ansprüche 6 - 8, wobei die besagte erste und zweite Oxid-Isolationsschicht (18; 21) eine Schicht aus Phosphor-Silikatglas "PSG" oder aus undotiertem Silikatglas "USG" ist.

10. Das Halbleiterbauteil nach Anspruch 6, oder einem der vorhergehenden Ansprüche 8 oder 9, wenn sie von Anspruch 6 abhängen, wobei die besagte erste Oxid-Isolationsschicht (21) eine Schicht aus Phosphor-Silikatglas "PSG" oder aus undotiertem Silikatglas "USG" ist.

## Revendications

1. Procédé de fabrication d'un dispositif semiconducteur comprenant les étapes qui consistent :
à former une région de contact métallique réfractaire (13) en tungstène sur un substrat (3), laquelle étape de formation est exécutée sous atmosphère réductrice ;
à former une couche intermédiaire (15) sur ladite région de contact métallique réfractaire (13) ;
à former une couche d'arrêt métallique (17) en nitrure de titane sur ladite couche intermédiaire (15), laquelle couche d'arrêt métallique (17) est destinée à empêcher l'oxydation de ladite région de contact (13) et de ladite couche intermédiaire (15), et dans lequel la matière dont la couche intermédiaire (15) est formée a pour propriété que le métal réfractaire de ladite région de contact métallique réfractaire est en meilleure conduction ohmique avec la matière de ladite couche intermédiaire (15) qu'avec la matière de ladite couche d'arrêt métallique (17) ;
à former un condensateur ferroélectrique (19) comprenant une électrode inférieure (19a), une couche ferroélectrique (19b) et une électrode supérieure (19c) sur ledit substrat (3), à une distance de ladite région de contact métallique réfractaire (13) ;
à former une première couche isolante d'oxyde (21) sur ladite couche d'arrêt métallique (17) et sur ledit condensateur ferroélectrique (19) ;
à former des trous de contact (CH2) dans ladite première couche isolante d'oxyde (21) pour atteindre ladite couche d'arrêt métallique (17) et lesdites électrodes inférieure et supérieur (19a, 19c) du condensateur ferroélectrique ; et
à former des électrodes de contact (23) dans lesdits trous de contact (CH2).

2. Procédé selon la revendication 1, comprenant en outre les étapes qui consistent :
à former une seconde couche isolante d'oxyde (18) sur ladite couche d'arrêt métallique (17) ;
à former ledit condensateur ferroélectrique (19) sur ladite seconde couche isolante d'oxyde (18) ;
à former ladite première couche isolante d'oxyde (21) sur ladite couche isolante d'oxyde (18) au-dessus de ladite région de contact métallique réfractaire (13) ;
à former lesdits trous de contact (CH2) dans lesdites première et seconde couches isolantes d'oxyde (18, 21).

3. Procédé selon chacune des revendications précédentes, dans lequel lesdites étapes de formation de ladite région de contact métallique réfractaire (13), de formation de ladite couche intermédiaire (15), de formation de ladite couche d'arrêt métallique (17) et de formation de ladite électrode de contact (23) sont exécutées en déposant du tungstène par dépôt chimique en phase vapeur, par pulvérisation de titane, par pulvérisation de nitrure de titane et par formation d'une électrode de contact (23) en aluminium, respectivement.

4. Procédé selon l'une quelconque des revendications précédentes, dans lequel ladite étape de formation de ladite première couche isolante d'oxyde (21) est une étape de formation d'une couche soit en verre de phospho-silicate "PSG", soit en verre de silicate non dopé "USG".

5. Procédé selon la revendication 1, ou l'une des revendications 3 et 4, lorsqu'elle dépend de la revendication 1, dans lequel ladite étape de formation de ladite seconde couche isolante d'oxyde (18) est une étape de formation d'une couche soit en verre de phospho-silicate "PSG", soit en verre de silicate non dopé "USG".

6. Dispositif semiconducteur comportant :
une région de contact métallique réfractaire (13) en tungstène sur un substrat (3) ;
une couche intermédiaire (15) sur ladite région de contact métallique réfractaire (13) ;
une couche d'arrêt métallique (17) en nitrure de titane sur ladite couche intermédiaire (15), la matière de ladite couche intermédiaire (15) ayant pour propriété que le métal réfractaire de ladite région de contact métallique réfractaire (13) est en meilleure conduction ohmique avec la matière de ladite couche intermédiaire (15) qu'avec la matière de ladite couche d'arrêt métallique (17) ;
une seconde couche isolante d'oxyde (18) sur ladite couche d'arrêt métallique (17) ;
un condensateur ferroélectrique (19) comprenant une électrode inférieure (19a), une couche ferroélectrique (19b) et une électrode supérieure (19c), lequel condensateur ferroélectrique (19) est disposé sur ladite seconde couche isolante d'oxyde (18) ;
une première couche isolante d'oxyde (21) sur ledit condensateur ferroélectrique (19) et sur ladite couche isolante d'oxyde (18) au-dessus de ladite région de contact métallique réfractaire (13) ;
des trous de contact (CH2), dans lesdites première et seconde couches isolantes d'oxyde (18, 21), atteignant ladite couche d'arrêt métallique (17) et lesdites électrodes inférieure et supérieure (19a, 19c) du condensateur ferroélectrique ; et
des électrodes de contact (23) dans lesdits trous de contact (CH2).

7. Dispositif semiconducteur comportant :
une région de contact métallique réfractaire (13) en tungstène sur un substrat (3) ;
une couche intermédiaire (15) sur ladite région de contact métallique réfractaire (13) ;
une couche d'arrêt métallique (17) en nitrure de titane sur ladite couche intermédiaire (15), la matière de ladite couche intermédiaire (15) ayant pour propriété que le métal réfractaire de ladite région de contact métallique réfractaire (13) est en meilleure conduction ohmique avec la matière de ladite couche intermédiaire (15) qu'avec la matière de ladite couche d'arrêt métallique (17) ;
un condensateur ferroélectrique (19) comprenant une électrode inférieure (19a), une couche ferroélectrique (19b) et une électrode supérieure (19c), lequel condensateur ferroélectrique (19) est disposé sur ledit substrat (3) à une certaine distance de ladite région de contact métallique réfractaire (13) ;
une première couche isolante d'oxyde (21) sur ladite couche d'arrêt métallique (17) et sur ledit condensateur ferroélectrique (19) ;
des trous de contact (CH2), dans ladite première couche isolante d'oxyde (21), atteignant ladite couche d'arrêt métallique (17) et lesdites électrodes inférieure et supérieure (19a, 19c) du condensateur ferroélectrique ; et
des électrodes de contact (23) dans lesdits trous de contact (CH2)

8. Dispositif semiconducteur selon l'une des revendications précédentes 6 et 7, dans lequel ladite couche intermédiaire (15) et lesdites électrodes de contact (23) sont en titane, et en aluminium, respectivement.

9. Dispositif semiconducteur selon l'une quelconque des revendications précédentes 6 à 8, dans lequel ladite première couche isolante d'oxyde (21) est une couche de verre de phospho-silicate "PSG" ou de verre de silicate non dopé "USG".

10. Dispositif semiconducteur selon la revendication 6, ou l'une des revendications 8 et 9 précédentes lorsqu'elle dépend de la revendication 6, dans lequel ladite seconde couche isolante d'oxyde (18) est une couche de verre de phospho-silicate "PSG" ou de verre de silicate non dopé "USG".
